# EUROPEAN PATENT APPLICATION

(11) **EP 2 028 694 A2**
(43) Date of publication of application: **25.02.2009**
(21) Application number: 08014712.7
(22) Date of filing: 19.08.2008
(51) Int. Cl.: H01L 29/778, H01L 29/872, H01L 29/861, H01L 29/10, H01L 29/06, H01L 29/205, H01L 29/47, H01L 29/51, H01L 29/423

(54) **Nitride semiconductor device and power converter including the same**

(30) Priority: 24.08.2007 JP 2007218128
(71) Applicant: Sharp Kabushiki Kaisha, Osaka-shi, Osaka 545-8522 (JP)
(72) Inventor: Oka, Tohru, Kitakatsuragi-gun Nara 636-0003 (JP)
(74) Representative: Müller - Hoffmann & Partner

(57) **Abstract**

A nitride semiconductor device includes a RESURF layer (3) containing p-type InₓGa₁₋ₓN (0 < x ≤ 1); a channel layer (4), formed on this RESURF layer, containing In_{y}Ga_{1-y}N (0 ≤ y < x); a barrier layer (5) including a nitride semiconductor layer, formed on this channel layer, having a wider energy gap than the channel layer; and a prescribed electrode (7-9, 11).

## Description

This nonprovisional application is based on Japanese Patent Application No. 2007-218128 filed on August 24, 2007, with the Japan Patent Office, the entire contents of which are hereby incorporated by reference.

### BACKGROUND OF THE INVENTION

### Field of the Invention

The present invention relates to a nitride semiconductor device and also a power converter including the same, and more particularly it relates to a nitride semiconductor device suitable for a high-power device required to have its high withstand voltage and operate with low electric loss and also a power converter including the same.

### Description of the Background Art

A semiconductor device formed by using nitride semiconductor material is expected to be suitable for a power device capable of performing high-current operation with high withstand voltage, due to the intrinsic characteristics of the material. In particular, a field-effect transistor (hereinafter referred to as HFET (Heterojunction Field-Effect Transistor)) or a diode using an AlGaN/GaN heterojunction can reduce electric resistance in on-state operation (hereinafter referred to as on-state resistance) through two-dimensional electron gas generated by influence of positive polarization charge at the heterojunction interface, and is therefore noted as a device capable of reducing electric loss.

In order to reduce the on-state resistance, it is desired to increase the concentration of the two-dimensional electron gas. However, when the HFET or the diode performs off-state operation, i.e., when a part near a drain side edge of a gate of the HFET or near a cathode side edge of an anode of the diode suffers depletion of carriers, the strength of an electric field formed in the depletion layer is increased as the concentration of the two-dimensional electron gas is increased, and hence the device is likely to break down at a lower operating voltage (i.e., the withstand voltage is lowered). Thus, there is a trade-off relation between the on-state resistance and the withstand voltage.

As a countermeasure for improving the on-state resistance or the withstand voltage by relaxing the strength of the electric field formed in the depletion layer, it is disclosed in U.S. Patent No. 6,100,549, for example, that a p-type layer having an electric property opposite to the two-dimensional electron gas is provided in the vicinity of a channel layer containing the two-dimensional electron gas so as to form the so-called RESURF structure. RESURF is the abbreviation for REduced SURface Field.

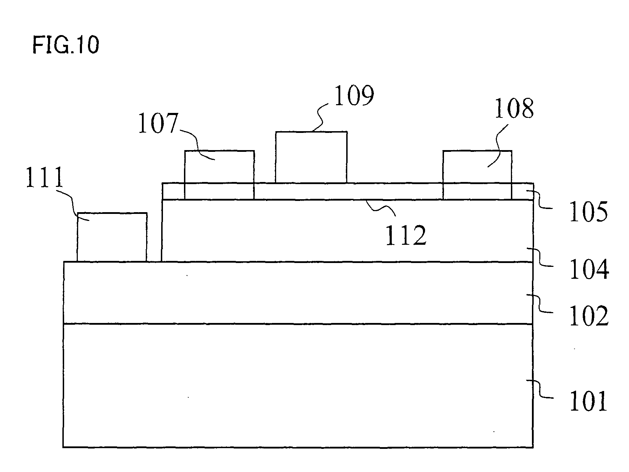

Fig. 10 shows a multilayer structure of a nitride semiconductor HFET including the RESURF structure disclosed in U.S. Patent No. 6,100,549. In the accompanying drawings, the dimensions such as length, width and thickness are arbitrarily modified in order to clarify and simplify the illustration, and do not correspond to the actual dimensions. In particular, the thicknesses are arbitrarily enlarged. In the drawings, identical reference numerals denote the same or corresponding portions.

The HFET of Fig. 10 includes a p-type GaN RESURF layer 102, an n-type GaN channel layer 104 and an AlGaN barrier layer 105 successively stacked on a substrate 101. This HFET also includes a source electrode 107, a drain electrode 108, a gate electrode 109 and an electrode 111 for the RESURF layer (hereinafter, an electrode for a RESURF layer is referred to as a RESURF layer electrode). Two-dimensional electron gas is formed at a heterojunction interface 112 between n-type GaN channel layer 104 and AlGaN barrier layer 105, due to influence of positive polarization charge.

In this HFET, p-type GaN RESURF layer 102 of at least 5 µm thickness having a dopant concentration of about 1.4 × 10¹⁶ to 6 × 10¹⁶ cm⁻³ is provided in connection with the two-dimensional electron gas having a sheet charge concentration of about 0.7 × 10¹³ to 3 × 10¹³ cm⁻² at heterojunction interface 112. According to this structure, in on-state operation, electric current flows through the two-dimensional electron gas having the high sheet charge concentration between source electrode 107 and drain electrode 108. Thus, low on-state resistance can be realized. In off-state operation, on the other hand, both of channel layer 104 and RESURF layer 102 are depleted when a large reverse bias voltage is applied between gate electrode 109 and drain electrode 108. At this time, an electric field caused by a p-type impurity in p-type GaN RESURF layer 102 weakens an electric field caused by both of positive polarization charge at heterojunction interface 112 and an n-type impurity in n-type GaN channel layer 104, whereby field strength in the depletion layer formed in the vicinity of gate electrode 109 can be reduced so as to improve the withstand voltage.

As hereinabove described, in U.S. Patent No. 6,100,549, RESURF layer 102 is formed by the p-type GaN layer having a thickness of at least 5 µm and a dopant concentration of not more than 10¹⁶ cm⁻³. In the case of reducing the distance between gate electrode 109 and drain electrode 108 for the purpose of the device's miniaturization or the like, however, RESURF layer 102 having the large thickness cannot be sufficiently depleted, and hence the effect of improving the withstand voltage is disadvantageously limited. This problem can conceivably be solved by increasing the hole concentration of p-type GaN RESURF layer 102. In general, however, it is not easy to obtain a p-type GaN layer having a high hole concentration. While GaN having a low activation ratio for a p-type impurity must be doped with an impurity at a concentration of at least 100 times the necessary hole concentration, the crystal quality is deteriorated and the hole concentration is rather reduced if the impurity concentration is excessively increased in an attempt to obtain a p-type GaN layer having a high hole concentration.

In consideration of the aforementioned problem of the conventional nitride semiconductor device having a RESURF structure, an object of the present invention is to provide a nitride semiconductor device having its reduced on-state resistance or improved withstand voltage by using a p-type RESURF layer having a high hole concentration for more effectively reducing the strength of an electric field formed in a semiconductor layer. By using this nitride semiconductor device, it is possible to provide a power converter capable of efficiently operating with low electric loss.

### SUMMARY OF THE INVENTION

A nitride semiconductor device according to an aspect of the present invention includes a RESURF layer containing p-type InₓGa₁₋ₓN (0 < x ≤ 1); a channel layer, formed on this RESURF layer, containing In_{y}Ga_{1-y}N (0 ≤ y < x); a barrier layer including a nitride semiconductor layer, formed on this channel layer, having a wider energy gap than the channel layer; a first anode electrode forming a Schottky junction with the barrier layer; a cathode electrode; and a RESURF layer electrode.

The cathode electrode is preferably in ohmic contact with the channel layer. The RESURF layer electrode is preferably in ohmic contact with the RESURF layer, and preferably electrically connected with the first anode electrode. The nitride semiconductor device can further include a second anode electrode in ohmic contact with the channel layer.

A nitride semiconductor device according to another aspect of the present invention includes a RESURF layer containing p-type InₓGa₁₋ₓN (0 < x ≤ 1); a channel layer, formed on this RESURF layer, containing InyGa_{1-y}N (0 ≤ y < x); a barrier layer including a nitride semiconductor layer; formed on this channel layer, having a wider energy gap than the channel layer; a gate electrode; a source electrode; a drain electrode; and a RESURF layer electrode.

The gate electrode and the barrier layer preferably form a Schottky junction. The nitride semiconductor device may include an insulating film between the gate electrode and the barrier layer. The drain electrode and the source electrode are preferably in ohmic contact with the channel layer. The RESURF layer electrode is preferably in ohmic contact with the RESURF layer, and preferably electrically connected with the source electrode.

In the aforementioned nitride semiconductor device, the distance between the RESURF layer and the barrier layer is preferably at least 20 nm. The uppermost surface layer of the channel layer is preferably made of GaN. The lowermost surface layer of the barrier layer is preferably made of AlN. The hole concentration of the RESURF layer is preferably at least 1 × 10¹⁸ cm⁻³. The In composition ratio x in the RESURF layer is preferably not more than 0.3. The RESURF layer preferably contains Mg as a p-type impurity.

A power converter according to the present invention includes at least one of the aforementioned nitride semiconductor devices.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic sectional view showing a multilayer structure of a nitride semiconductor HFET according to a first embodiment of the present invention;
Fig. 2 is a graph showing the relation between the field strength (MV/cm) at the drain side edge of the gate and the on-state resistance (Ωmm) in the HFET of Fig. 1 in comparison with a comparative HFET;
Fig. 3 is a graph showing the relation between the thickness (nm) of the channel layer and the on-state resistance (Ωmm) in the HFET of Fig. 1;
Fig. 4 is a schematic sectional view showing a modification of the HFET of Fig. 1;
Fig. 5 is a schematic sectional view showing another modification of the HFET of Fig. 1;
Fig. 6 is a schematic sectional view showing a multilayer structure of a nitride semiconductor HFET according to a second embodiment of the present invention;
Fig. 7 is a schematic sectional view showing a multilayer structure of a nitride semiconductor diode according to a third embodiment of the present invention;
Fig. 8 is a schematic sectional view showing a modification of the diode of Fig. 7;
Fig. 9 is a circuit diagram showing a main part of a power converter according to a fourth embodiment of the present invention; and
Fig. 10 is a schematic sectional view showing a multilayer structure of a conventional nitride semiconductor HFET.

### DESCRIPTION OF THE PREFERRED EMBODIMENTS

### (First Embodiment)

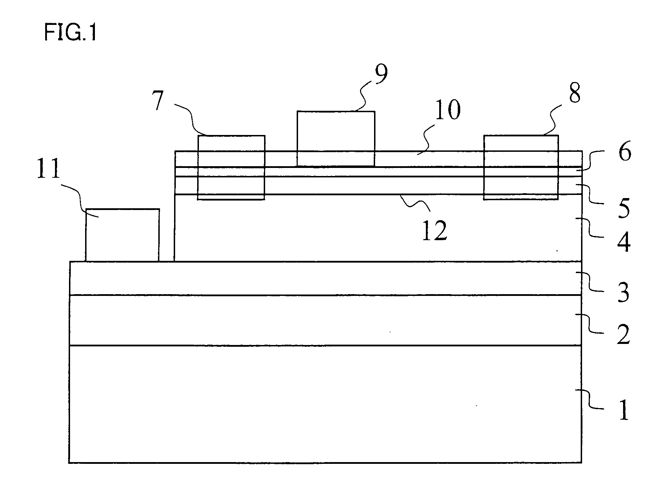

Fig. 1 is a schematic sectional view showing a multilayer structure of an HFET as a nitride semiconductor device according to a first embodiment of the present invention. This HFET includes an AlN buffer layer 2, a p-type InGaN RESURF layer 3, an undoped GaN channel layer 4, a barrier layer 5 including an undoped AlGaN/AlN multilayer film, and an undoped GaN cap layer 6 successively stacked on an Si substrate 1. This HFET also includes a Ti/Al source electrode 7, a Ti/Al drain electrode 8, an Ni/Au gate electrode 9, an SiN/SiO₂ insulating film 10 and a Pd/Au RESURF layer electrode 11.

At a heterojunction interface 12 between channel layer 4 and barrier layer 5, a channel is formed by two-dimensional electron gas due to influence of positive polarization charge. Source electrode 7 and drain electrode 8 are in ohmic contact with the channel formed by the two-dimensional electron gas. Gate electrode 9 is formed on cap layer 6 and forms a Schottky junction with barrier layer 5 through cap layer 6. RESURF layer electrode 11 is in ohmic contact with RESURF layer 3 and electrically connected with source electrode 7.

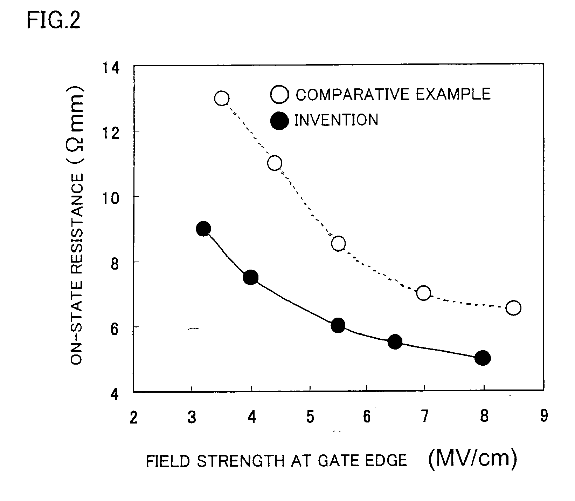

Fig. 2 is a graph showing the relation between the field strength (MV/cm) at the drain side edge of the gate and the on-state resistance (Ωmm), as a result of calculation using a device simulator in connection with the HFET of Fig. 1 and a comparative HFET. In this graph, a black circle shows a result of calculation in connection with the HFET of Fig. 1 and a white circle shows a result of calculation in connection with the comparative HFET.

In this simulation, it has been investigated how the relation between the field strength at the drain side edge of the gate and the on-state resistance changes depending on the concentration of the two-dimensional electron gas at heterojunction interface 12, under the condition that source electrode 7 and RESURF layer electrode 11 both were connected to the ground potential, and voltages of -10 V and 300 V were applied to gate electrode 9 and drain electrode 8 respectively. In this case, it was assumed for p-type InGaN RESURF layer 3 that the thickness was 50 nm, the In composition ratio in group III elements was 0.1, the concentration of Mg used as a p-type impurity was 2 × 10¹⁹ cm⁻³, the activation ratio thereof was 10 %, and the hole concentration was 2 × 10¹⁸ cm⁻³. It was also assumed that the thickness of channel layer 4 was 100 nm. The concentration of the two-dimensional electron gas at heterojunction interface 12 was varied by adjusting the Al composition in group III elements contained in the AlGaN layer included in barrier layer 5 and also adjusting the thicknesses of this AlGaN layer and the AlN layer.

The graph of Fig. 2 shows a result obtained by varying, in the range of 0.5 to 2, the ratio between the sheet density of holes in RESURF layer 3 and the sheet density of the two-dimensional electron gas at heterojunction interface 12. As seen from this graph, the on-state resistance is reduced and the field strength is increased when the concentration of the two-dimensional electron gas is increased. In other words, the concentration of the two-dimensional electron gas is increased from the upper left side toward the lower right side along each of the curves in the graph of Fig. 2.

The comparative HFET was different from the HFET of Fig. 1 only in a point that a conventional p-type GaN layer was used as a RESURF layer. For the p-type GaN RESURF layer included in this comparative HFET, it was assumed that the activation ratio of Mg was 1 %, and the hole concentration was 2 × 10¹⁷ cm⁻³. The difference between the activation ratios for Mg in GaN and InGaN is reported in K. Kumakura et al., "Activation Energy and Electrical Activity of Mg in Mg-Doped InxGa1-xN (x < 0.2)", Japanese Journal of Applied Physics, vol. 39, pp. L337 to L339, 2000, for example.

As shown in Fig. 2, it is understood that the HFET of Fig. 1 can more reduce the on-resistance as compared with the comparative HFET at the same field strength. It is also understood that the HFET of Fig. 1 can more reduce the field strength at the drain side edge of the gate, i.e., can improve the withstand voltage, as compared with the comparative HFET at the same on-state resistance.

While Fig. 2 shows the result obtained by varying in the range of 0.5 to 2 the ratio between the sheet densities of the holes in RESURF layer 3 and the two-dimensional electron gas at heterojunction interface 12, it has been confirmed also outside the range of 0.5 to 2 that the HFET according to the present invention exhibits the effect of more reducing the field strength as compared with the comparative HFET.

As hereinabove described, since the p-type InGaN layer is used as RESURF layer 3 in the HFET of Fig. 1, the hole concentration in RESURF layer 3 can be increased as compared to the prior art even with the same concentration of the added p-type impurity, and it becomes possible to reduce the strength of the electric field formed at the drain side edge of the gate in off-state operation of the HFET. Consequently, in the HFET of Fig. 1 having the same withstand voltage as that of the conventional HFET, it is possible to increase the two-dimensional electron gas concentration and thus it becomes possible to reduce the on-state resistance and electric loss. Further, the HFET of Fig. 1 generating the two-dimensional electron gas concentration that causes the same on-state resistance as in the conventional HFET can have a higher withstand voltage.

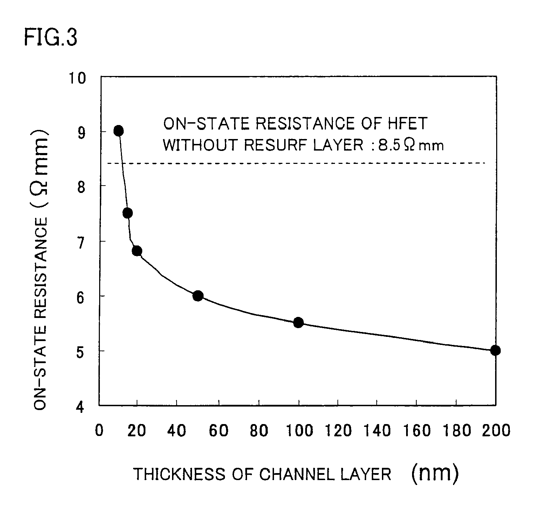

Fig. 3 is a graph showing the relation between the thickness (nm) of channel layer 4 and the on-state resistance (Ωmm) in the HFET of Fig. 1, as a result of calculation using a device simulator. In this simulation, the thickness of channel layer 4 was varied while the concentration of the two-dimensional electron gas was set to 1.5 × 10¹³ cm⁻² and the hole concentration of p-type InGaN RESURF layer 3 was set to 2 × 10¹⁸ cm⁻³. Bias conditions for the HFET in the simulation shown in Fig. 3 were identical to those in the case of Fig. 2.

It is understood from Fig. 3 that the on-state resistance is increased as the thickness of channel layer 4 is reduced. The reason of this is that RESURF layer 3 approaches channel layer 4 and thus the concentration of the two-dimensional electron gas is reduced also in on-state operation. Particularly when the thickness of channel layer 4 is reduced to about 10 nm, the concentration of the two-dimensional electron gas is remarkably reduced, and the on-state resistance is increased even as compared to the on-state resistance 8.5 Ωmm of the HFET without RESURF layer 3. It is understood from this result that the distance between RESURF layer 3 and the two-dimensional electron gas of channel layer 4, i.e., heterojunction interface 12, is preferably at least 20 nm, in order to more effectively carry out the present invention.

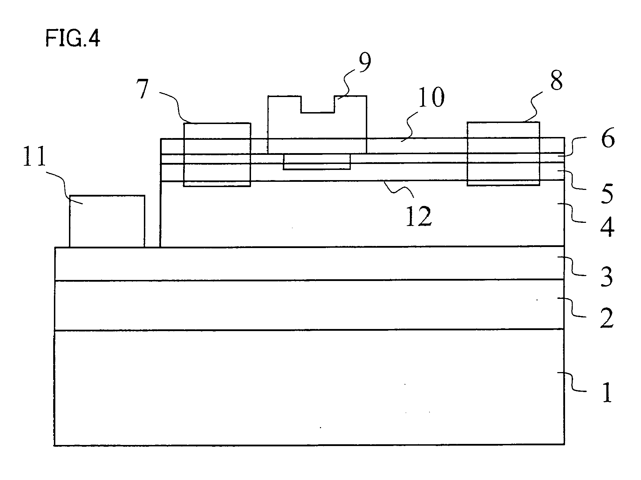

Fig. 4 is a schematic sectional view showing a modification of the HFET of Fig. 1. The HFET of Fig. 4 has the so-called recessed structure. Specifically, a recess is formed by partially removing cap layer 6 and barrier layer 5, and gate electrode 9 forms a Schottky junction with barrier layer 5 exposed in this recess. With this recessed structure, the distance between gate electrode 9 and the two-dimensional electron gas, i.e., channel layer 4, is reduced, whereby making it possible to shift the threshold voltage to the positive side and improve the mutual conductance.

Also in this HFET having the recessed structure, the field strength at the drain side edge of the gate in off-state operation can be reduced by using a p-type InGaN layer as RESURF layer 3. Consequently, the two-dimensional electron gas concentration can be increased in the HFET of Fig. 4 as compared with the prior art, whereby making it possible to reduce the on-state resistance and electric loss. Further, the HFET of Fig. 4 can have a high withstand voltage when it has a two-dimensional electron gas concentration causing the same on-state resistance as the prior art.

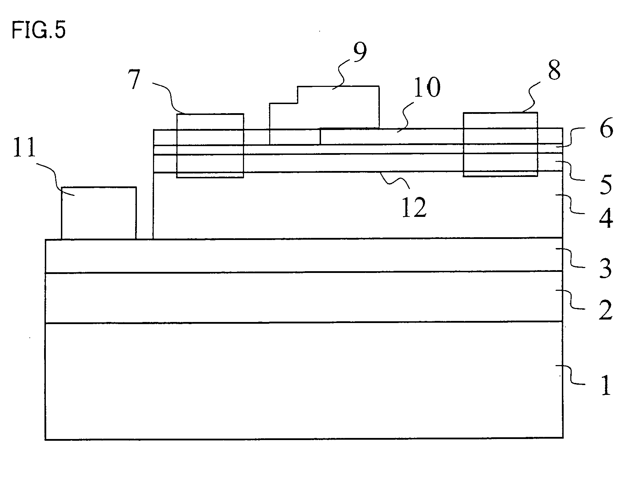

Fig. 5 is a schematic sectional view showing another modification of the HFET of Fig. 1. The HFET of Fig. 5 has the so-called field-plate structure. Specifically, gate electrode 9 forms a Schottky junction with barrier layer 5 through cap layer 6 and is partially formed also on insulating film 10. In this HFET, the field strength at the drain side edge of the gate is reduced due to a field-plate effect, and the withstand voltage can be improved.

Also in this HFET having the field-plate structure, the field strength at the drain side edge of the gate in off-state operation can be reduced by using a p-type InGaN layer as RESURF layer 3. Consequently, the two-dimensional electron gas concentration can be increased in the HFET of Fig. 5 at the same withstand voltage as the prior art, whereby making it possible to reduce the on-state resistance and electric loss. Further, the HFET of Fig. 5 can have a high withstand voltage when it has a two-dimensional electron concentration causing the same on-state resistance as the prior art.

### (Second Embodiment)

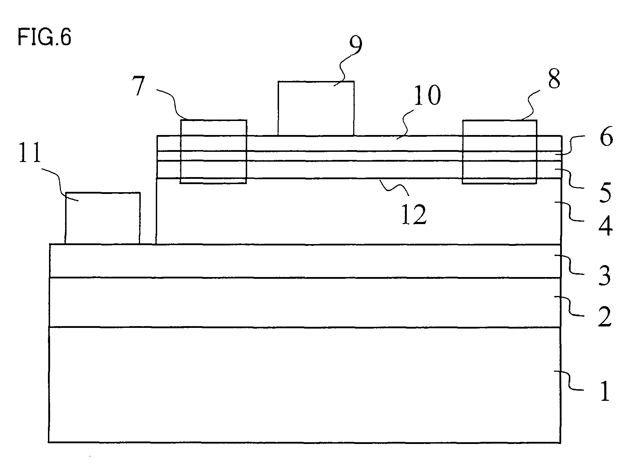

Fig. 6 is a schematic sectional view showing a multilayer structure of an HFET as a nitride semiconductor device according to a second embodiment of the present invention. This HFET is the so-called MIS (Metal-Insulator-Semiconductor) device having a gate electrode 9 formed on an insulating film 10. Specifically, insulating film 10 insulates gate electrode 9 and a barrier layer 5 from each other, and leakage current flowing through gate electrode 9 is suppressed so as to improve the withstand voltage. Also in this MIS-type HFET, the field strength at the drain side edge of the gate in off-state operation can be reduced by using a p-type InGaN layer as a RESURF layer 3. Consequently, the two-dimensional electron gas concentration can be increased in the HFET of Fig. 6 at the same withstand voltage as the prior art, whereby making it possible to reduce the on-state resistance and electric loss. Further, the HFET of Fig. 6 can have a high withstand voltage when it has a two-dimensional electron concentration causing the same on-state resistance as the prior art.

### (Third Embodiment)

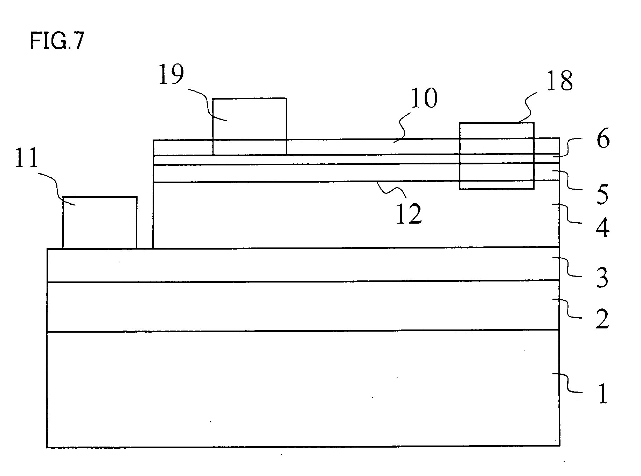

Fig. 7 is a schematic sectional view showing a multilayer structure of a diode as a nitride semiconductor device according to a third embodiment of the present invention. This diode includes semiconductor layers 1 to 6 and an insulating film 10 similar to those of the aforementioned HFETs, as well as a RESURF layer electrode 11, a Ti/Al cathode electrode 18 and an Ni/Au anode electrode 19.

Also in the diode of Fig. 7, a channel is formed at a heterojunction interface 12 between channel layer 4 and barrier layer 5 by two-dimensional electron gas due to influence of positive polarization charge. Cathode electrode 18 is in ohmic contact with the channel of the two-dimensional electron gas. Anode electrode 19 is formed on cap layer 6 and forms a Schottky junction with barrier layer 5 through cap layer 6. RESURF layer electrode 11 is in ohmic contact with RESURF layer 3 and electrically connected with anode electrode 19.

Also in this diode, the hole concentration of RESURF layer 3 can be increased as compared with the prior art by using a p-type InGaN layer as RESURF layer 3. Thus, it is possible to reduce the strength of the electric field formed at the cathode side edge of the anode in reverse bias operation of the diode. Consequently, the two-dimensional electron gas concentration can be increased in the diode of Fig. 7 at the same withstand voltage as the prior art, whereby making it possible to reduce the on-state voltage and electric loss in forward bias operation. Further, the diode of Fig. 7 can have a high withstand voltage when it has a two-dimensional electron gas concentration causing the same on-state voltage as the prior art.

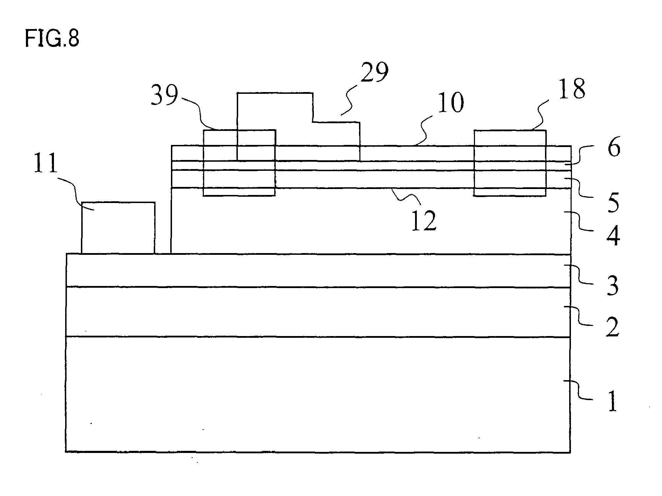

Fig. 8 is a schematic sectional view showing a modification of the diode of Fig. 7. An anode electrode of the diode of Fig. 8 includes a first anode electrode 29 forming a Schottky junction with barrier layer 5 through cap layer 6 and a second anode electrode 39 electrically connected with first anode electrode 29 and in ohmic contact with the channel of the two-dimensional electron gas. When the voltage of the anode electrode is 0 V in this diode, depletion is caused in channel layer 4 under the anode electrode by influence of the Schottky barrier of first anode electrode 29, and thus the current path is pinched off so that the current is cut off. When a forward bias voltage is applied to the anode electrode, a channel is formed under first anode electrode 29, and electrons flow from second anode electrode 39 to cathode electrode 18.

In the diode of Fig. 8, therefore, the threshold voltage in forward bias operation can approximate 0 V and the operation at a lower on-state voltage can be realized as compared to the diode of Fig. 7. When a reverse bias voltage is applied to the diode of Fig. 8, on the other hand, the channel is depleted in a region from under first anode electrode 29 toward cathode electrode 18 to cut off the current, whereby making it possible to realize the same withstand voltage as the diode of Fig. 7. Also in the diode of Fig. 8, the hole concentration of RESURF layer 3 can be increased as compared with the prior art by using a p-type InGaN layer as RESURF layer 3. In the diode of Fig. 8, therefore, it is possible to reduce the strength of the electric field formed at the cathode side edge of the anode in the reverse bias operation. Consequently, the two-dimensional electron gas concentration can be increased at the same withstand voltage as the prior art, whereby making it possible to reduce the on-state voltage and electric loss in forward bias operation. Further, the diode of Fig. 8 can have a higher withstand voltage when it has a two-dimensional electron gas concentration causing the same on-state voltage as the prior art.

### (Fourth Embodiment)

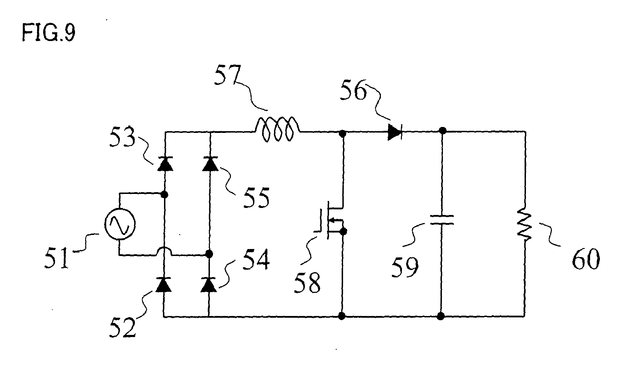

Fig. 9 is a circuit diagram showing a main part of a power factor control circuit in a power converter according to a fourth embodiment of the present invention. The circuit of Fig. 9 includes an AC power source 51, diodes 52 to 56, an inductor 57, an HFET 58, a capacitor 59 and a load resistance 60. The diode of Fig. 8 is used as each of diodes 52 to 56, and the HFET of Fig. 6 is used as HFET 58.

Since the power factor control circuit in the power converter of Fig. 9 includes the HFET of Figs. 6 and the diode of Fig. 8 as HFET 58 and each of diodes 52 to 56 respectively, it is possible to deduce electric loss in the circuit. Therefore, the power factor control circuit of Fig. 9 can realize improved efficiency and can perform efficient operation with low electric loss.

The present invention is not restricted to the aforementioned embodiments, and it goes without saying that various modifications are possible within the technical idea of the present invention.

For example, while buffer layer 2 is made of AlN in each of the aforementioned embodiments, another nitride semiconductor such as GaN, AlGaN or AIN/GaN may alternatively be used for buffer layer 2.

While the In composition ratio in the group III elements contained in p-type InGaN RESURF layer 3 is set to 0.1 in each of the aforementioned embodiments, the present invention is not restricted to this In composition ratio, as a matter of course. If the In composition ratio is excessively increased in p-type InGaN RESURF layer 3, however, the thickness of RESURF layer 3 cannot be increased because of increased lattice-mismatch with buffer layer 2. In this case, the influence of reduction of critical layer thickness for obtaining a high-quality crystal layer becomes more dominant than the effect of improving the activation ratio in the p-type impurity, and it becomes difficult to obtain a high sheet density of the holes. In order to increase the sheet density of the holes in p-type InGaN RESURF layer 3, therefore, the In composition ratio is desirably not more than 0.3. The thickness of p-type InGaN RESURF layer 3 is not restricted to 50 nm, and it can be set to a designed value suitable for the sheet density of the holes or the In composition ratio necessary for realizing desired on-state resistance.

While single undoped GaN channel layer 4 is used in each of the aforementioned embodiments, it is possible to alternatively use a channel layer including a single layer or a plurality of layers of undoped or doped AlGaN, InGaN, GaN/AlGaN or InGaN/GaN. If an InGaN layer is used as channel layer 4, however, there is a possibility that the p-type impurity diffuses from p-type InGaN RESURF layer 3 into channel layer 4. Therefore, the In composition ratio of channel layer 4 is preferably set lower than that of RESURF layer 3 so that the hole concentration of channel layer 4 can be lower than that of RESURF layer 3. The reason of this is that the activation ratio for the p-type impurity and then the hole concentration tend to be increased as the In composition ratio is increased. Channel layer 4 may also be a semiconductor layer of doped n-type GaN or p-type GaN. In order to realize low on-state resistance, however, the mobility of the two-dimensional electron gas must be increased, and hence at least the uppermost surface layer of channel layer 4 is most preferably made of undoped GaN having an In composition ratio of 0.

While undoped GaN cap layer 6 is provided on barrier layer 5 formed by the undoped AlGaN/AlN multilayer film in each of the aforementioned embodiments, cap layer 6 may alternatively be made of another nitride semiconductor such as InGaN, or may alternatively be omitted. If cap layer 6 is omitted, gate electrode 9 or anode electrode 19 is directly formed on barrier layer 5. Further, barrier layer 5 may alternatively be formed by a single undoped or doped AlGaN layer, a multilayer AlGaN film including a plurality of AlGaN layers having different Al composition ratios and impurity concentrations, or a multilayer nitride semiconductor film containing GaN/AlGaN or InGaN/AlGaN. However, the mobility of the two-dimensional electron gas must be increased in order to obtain low on-state resistance, and hence at least the lowermost surface layer of barrier layer 5 is preferably made of AlN rather than AlGaN which is a ternary mixed crystal causing mobility reduction due to scattering.

While each of source electrode 7 and drain electrode 8 is formed with Ti/Al in each of the aforementioned embodiments, it may alternatively be formed with another electrode material such as Ti/Au, Hf/Au or Ni/Au, as a matter of course.

While each of gate electrode 9 and anode electrode 19 is formed with Ni/Au in each of the aforementioned embodiments, it may alternatively be formed with another electrode material such as Ti/Au, Ti/Al, Pd/Au, Pt/Au, W, WNₓ or WSiₓ, as a matter of course.

While RESURF layer electrode 11 is formed with Pd/Au in each of the aforementioned embodiments, it may alternatively be formed with another electrode material such as Pt/Au, Ni/Au, W, WNₓ or WSiₓ, as a matter of course.

While each of source electrode 7, drain electrode 8 and cathode electrode 18 is in ohmic contact with channel layer 4 in each of the aforementioned embodiments, it may alternatively form a Schottky junction with channel layer 4. In order to reduce the on-state resistance and electric loss in the nitride semiconductor device, however, each of these electrode is preferably in ohmic contact with channel layer 4.

While RESURF layer electrode 11 and RESURF layer 3 are in ohmic contact with each other in each of the aforementioned embodiments, they may alternatively form a Schottky junction. However, it is preferable that RESURF layer electrode 11 and RESURF layer 3 form an ohmic contact in order to reduce electric loss, for example, in the case that a large current flows in RESURF layer 3 and then the on-state resistance is remarkably reduced.

While insulating film 10 is formed with SiN/SiO₂ in each of the aforementioned embodiments, it may alternatively be formed with SiO₂, SiN, Al₂O, HfO₂, TiO₂, TaOₓ, MgO, Ga₂O₃ or an SiN/SiO₂/SiN multilayer film, as a matter of course.

While the hole concentration of p-type InGaN RESURF layer 3 is set to 2 × 10¹⁸ cm⁻³ in each of the aforementioned embodiments, the present invention is not restricted to this hole concentration, as a matter of course. However, a hole concentration of at least 1 × 10¹⁸ cm⁻³ is hard to obtain in p-type GaN, and hence the present invention brings more meritorious effect in the case that the hole concentration is at least 1 × 10¹⁸ cm⁻³ cm⁻³.

While Mg is used as the p-type impurity in RESURF layer 3 in each of the aforementioned embodiments, another p-type impurity such as Be may alternatively be used.

While the power factor control circuit including the nitride semiconductor devices such as HFET 58 and diodes 52 to 56 according to the present invention is exemplarily shown in the aforementioned fourth embodiment, the nitride semiconductor device according to the present invention is also applicable to another power converter such as an inverter or a converter. The nitride semiconductor device according to the present invention may be applied to only a part of such a power converter, as a matter of course.

According to the present invention as hereinabove described, the strength of the electric field formed in depletion of a part near the gate or anode electrode can be reduced by using the p-type InGaN RESURF layer that can has a high hole concentration, and thus it becomes possible to provide a nitride semiconductor device having its high withstand voltage or small on-state resistance and causing less electric loss. Furthermore, by utilizing this nitride semiconductor device, it is also possible to provide a power converter capable of efficiently operating with low electric loss.

Although the present invention has been described and illustrated in detail, it is clearly understood that the same is by way of illustration and example only and is not to be taken by way of limitation, the scope of the present invention being interpreted by the terms of the appended claims.

## Claims

1. A nitride semiconductor device comprising:
a RESURF layer (3) including p-type InₓGa₁₋ₓN (0 < x ≤ 1);
a channel layer (4), formed on said RESURF layer, including In_{y}Ga_{1-y}N (0 ≤ y < x);
a barrier layer (5) including a nitride semiconductor layer, formed on said channel layer, having a wider energy band gap than said channel layer;
a first anode electrode (19, 29, 39) forming a Schottky junction with said barrier layer;
a cathode electrode (18); and
a RESURF layer electrode (11).

2. The nitride semiconductor device according to claim 1, wherein
said RESURF layer electrode is in ohmic contact with said RESURF layer.

3. The nitride semiconductor device according to any of claims 1 or 2, wherein
said RESURF layer electrode is electrically connected with said first anode electrode.

4. The nitride semiconductor device according to any of claims 1 to 3, further comprising a second anode electrode in ohmic contact with said channel layer.

5. A nitride semiconductor device comprising:
a RESURF layer (3) including p-type InₓGa₁₋ₓN (0 < x ≤ 1);
a channel layer (4), formed on said RESURF layer, including In_{y}Ga_{1-y}N (0 ≤ y < x);
a barrier layer (5) including a nitride semiconductor layer, formed on said channel layer, having a wider energy gap than said channel layer;
a gate electrode (9);
a source electrode (7);
a drain electrode (8); and
a RESURF layer electrode (11).

6. The nitride semiconductor device according to claim 5, wherein
said gate electrode and said barrier layer form a Schottky junction.

7. The nitride semiconductor device according to claim 5 or 6, further comprising an insulating film between said gate electrode and said barrier layer.

8. The nitride semiconductor device according to any of claims 5 to 7, wherein
said RESURF layer electrode is in ohmic contact with said RESURF layer.

9. The nitride semiconductor device according to any of claims 5 to 8, wherein
said RESURF layer electrode is electrically connected with said source electrode.

10. The nitride semiconductor device according to any of claims 1 to 9, wherein
the distance between said RESURF layer and said barrier layer is at least 20 nm.

11. The nitride semiconductor device according to any of claims 1 to 10, wherein
the uppermost surface layer of said channel layer is made of GaN.

12. The nitride semiconductor device according to any of claims 1 to 11, wherein
the lowermost surface layer of said barrier layer is made of AlN.

13. The nitride semiconductor device according to any of claims 1 to 12, wherein
the hole concentration of said RESURF layer is at least 1 × 10¹⁸ cm⁻³.

14. The nitride semiconductor device according to any of claims 1 to 13, wherein
the In composition ratio x in said RESURF layer is not more than 0.3.

15. A power converter including the nitride semiconductor device of any of claims 1 to 14.
